# EUROPEAN PATENT SPECIFICATION

(11) **EP 3 008 972 B1**
(45) Date of publication and mention of the grant of the patent: **12.07.2017**
(21) Application number: 14731059.3
(22) Date of filing: 20.05.2014
(51) Int. Cl.: H05B 6/36, H05B 6/42, H05K 3/46

(54) **MINIATURIZED HEAD FOR INDUCTION WELDING OF PRINTED CIRCUITS**
MINIATURISIERTER KOPF ZUM INDUKTIONSSCHWEISSEN VON LEITERPLATTEN
TÊTE MINIATURE POUR SOUDAGE PAR INDUCTION DE CIRCUITS IMPRIMÉS

(30) Priority: 13.06.2013 IT GE20130058
(43) Date of publication of application: 20.04.2016
(73) Proprietor: Cedal Equipment S.r.l., 20138 Milano (IT)
(72) Inventor: CERASO, Bruno, 21041 Albizzate (VA) (IT)
(74) Representative: Ferroni, Filippo
(86) International application number: PCT/IB2014/061556
(87) International publication number: WO 2014/199251

(56) References cited:
- WO-A1-2004/105993
- WO-A1-2009/063515
- WO-A2-2008/028005
- WO-A2-2012/052877

## Description

The present invention relates to an inductive head for joining layers intended for making printed circuits.

For a better understanding of the invention and of the explanation thereof that will follow, it is worth providing a brief overview of the printed circuit production process, to which the invention preferably applies.

As is known, printed circuits for electronic applications, such as those used in computers (e.g. PC's), telephones and other telecommunications equipment, household appliances, machine tools and the like, are obtained by stacking up multiple conducting layers incorporating tracks designed in accordance with the circuit's topography, with layers of electrically insulating material in between.

The production of printed circuits is a rather complex cycle that requires many steps, starting from the making of conducting sheets with the circuit tracks printed according to the project design or topography, until such sheets are assembled to create so-called "multilayers", which are stacks of laminates obtained by overlapping conducting layers alternated with insulating layers.

The latter consist of the so-called "pre-preg", i.e. a synthetic fabric impregnated with electrically insulating epoxy resins, which cure when heated in a hot-pressing step, so as to form a single sheet together with the stacked conducting layers.

Printed circuits obtained by using this technology can be either rigid, like those commonly used for electronic boards, or flexible, like those, for example, used for wired connections of components of electronic computers (PC's and the like), printers, photocopiers and other machines in general; their thickness may vary from a few tenths of a millimetre to a few millimetres.

With the development of consumer computer and telecommunication technologies and equipment (Internet network, mobile phones, laptops, tablets, satellite navigation systems, etc.), in particular of the latest generation thereof, the functions performed by electronic circuits have become increasingly complex.

This requires higher performance levels, without however adversely affecting the lightness and portability of the devices, which, on the contrary, are evolving with a tendency towards smaller size and thickness.

Producers are forced by this increasingly stringent situation to reduce the components' weight to a minimum; this translates into lighter and thinner components which have undergone a technological evolution, meaning by this that the number of layers to be stacked for making the so-called "multilayers" has been increased, while their thickness has been decreased in order not to change the overall dimensions of the apparatuses in which the circuits are to be installed.

To give an idea of the dimensions involved, a finished laminated sheet is about one millimetre thick, and therefore the layers (at least one conducting layer with the circuit tracks and one "pre-preg" insulating layer) that compose it have a thickness that varies from a few hundredths to a few tenths of a millimetre (typically 30-40 microns to 500-600 microns).

It follows that the manufacture of multilayer laminates has now become much more difficult and exacting, technologically speaking, than it was in the past; in fact, it must be pointed out that the higher the number of layers that have to be stacked up, the more precisely they must be applied one onto the other, otherwise the circuit will turn out to be defective.

After all, if the single layers are just a few tens of microns thick, the overlapping tolerances will be of the same order of magnitude (i.e. microns).

The present invention fits into this technological context.

In fact, the present Applicant developed in the past a method for making stacks of multilayer laminates, which includes a final compaction and thermal junction step in a suitable heating press.

In order to obtain the desired final product, i.e. a printed circuit having specific structural and functional characteristics, it is necessary that the overlapping of the conducting and insulating layers in the multilayer stack is very precise.

To this end, relative movements between layers must be prevented during the various multilayer stack processing steps; for this reason, it is known to make a junction at various points of the stacked layers to prevent them from moving, so that the multilayer stack can be manipulated.

In recent years, various welding techniques have been developed with more or less satisfactory results, which are based on local heating of the multilayer stack; for example, machines have been built wherein the thermal energy necessary for making the junction is applied by means of electrodes heated by electric resistors, or wherein radiating energy is used in the form of microwaves or electromagnetic induction.

For example, the present Applicant has filed an international patent application under number PCT/IB2011/54486, which relates to a method, and a machine for the implementation thereof, wherein multilayer stacks of printed circuits can be welded by using electromagnetic induction heads in various spots along the edge, depending on the dimensions of the laminates that make up the stack.

For this purpose, the induction heads are fitted with substantially C-shaped electromagnets, the North-South poles of which act simultaneously at respective points of the edge of the stacked laminates, along the peripheral belt where there are metallic spacers intended for the passage of the melted resin.

These spacers are rises in the conducting layers, which, when a magnetic induction field is applied thereto, are crossed by electric currents that produce the heat necessary for locally melting the thermosetting resin that impregnates the insulating substrates (pre-preg).

The locally hardened resin welds the layers at the spacers' locations, thus ensuring the desired stable configuration of the multilayer stack, which can then undergo further processing steps.

This technology developed by the present Applicant has given very interesting results; therefore, it is one object of the present invention to develop it further.

To this end, it would be desirable to be able to use it for a large number of junction spots, so as to be able to attain better results; as can be easily understood, in fact, if the stacked layers are welded in a larger number of spots along their edge, a better junction will be obtained because it will be distributed more evenly with respect to the stack of laminates, the junction being also safer because, in the event that one junction spot should be defective, it will still be ensured by the other spots, which will be more numerous and closer to each other than what can currently be obtained with the usual machines.

In the light of the above explanation, it can be stated that the technical problem at the basis of the present invention is to provide an induction welding head that allows joining the stacked layers intended for the production of printed circuits in spots closer to each other, so as to obtain more uniformity and reliability of the junction as a whole.

The idea for solving this problem is to provide an induction head which is smaller than the known ones; in fact, this allows using a larger number of heads, distributed along the edge of the stacked laminates, for welding them in corresponding spots.

In accordance with the invention, the induction heads are advantageously cooled, so that their dimensions can be reduced; the ferromagnetic material heated by the induction it is subjected to during the welding process will still operate at temperatures allowing the head to work properly in the conditions required for making the junction.

The features of the induction head according to the invention are set out in the claims appended to this description.

These features and the effects deriving therefrom, as well as the advantages of the present invention, will become more apparent from the following description of an example of embodiment thereof as shown in the annexed drawings, which are supplied by way of non-limiting example, wherein:

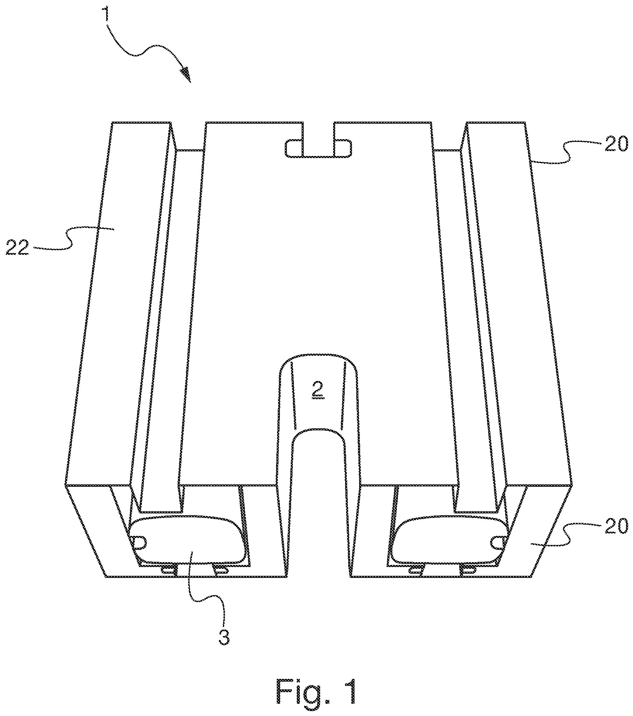

Fig. 1 is a perspective view of an induction welding head according to the present invention;

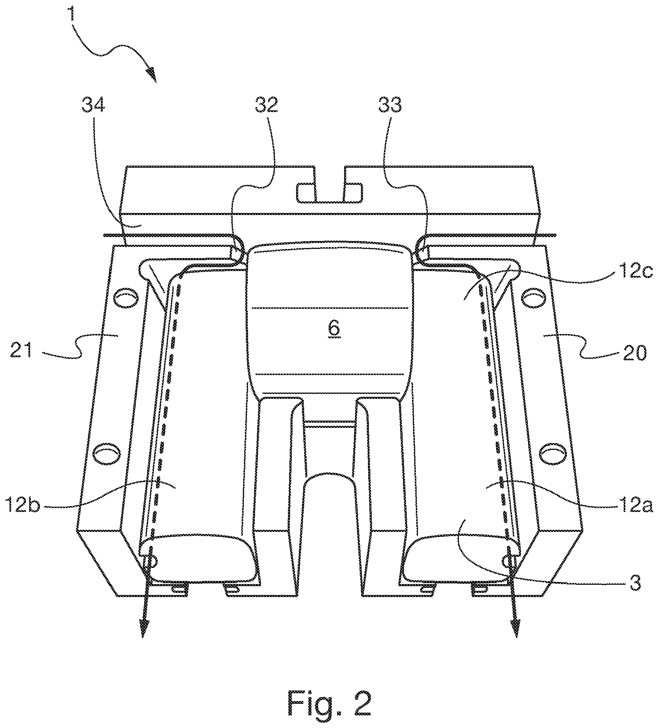

Fig. 2 shows the welding head of Fig. 1, with a part thereof removed;

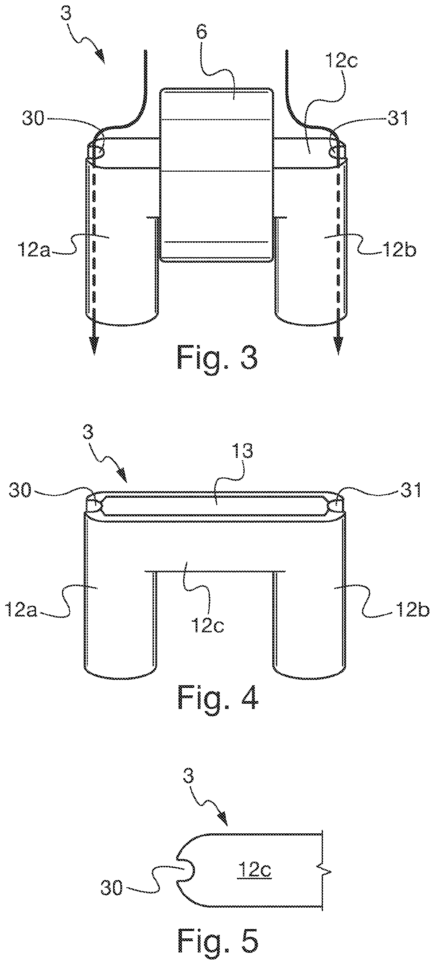

Fig. 3 shows a detail of the welding head of Figures 1 and 2;
Fig. 4 shows the detail of the welding head of Fig. 3, with a part thereof removed;
Fig. 5 is a close-up view of a part of the detail of Figs. 3 and 4;
Fig. 6 shows an application of the induction head according to the invention;
Fig. 7 shows a detail of a ferromagnetic element used in the application of Fig. 6.

With reference to the above-listed Figures, the first thereof shows a general view of the induction head 1 according to the invention, which comprises an external structure 2 that houses a first inductor core 3, made of ferromagnetic material and substantially C-shaped.

The inductor core 3 supports an excitation inductance or coil 6 and is magnetically coupled to a second inductor core 4.

Both inductor cores 3 and 4 are made of a material permeable to a concatenated magnetic flux generated by the inductance 6, when the latter is excited by an alternating current having a frequency of the order of several kHz, preferably between 18 kHz and 30 kHz, in this specific case approx. 24 kHz.

The material permeable to magnetic flux used for making the inductor cores is preferably ferrite: by using ferrite, it is possible to limit the parasitic currents induced by the variable magnetic flux, without having to resort to lamination of the core material.

If a simple ferromagnetic material were used (e.g. soft iron), such parasitic currents would heat the cores 3 and 4 excessively, unless the latter are provided in the form of sheet stacks, like transformers.

The first inductor core 3 is preferably C-shaped or U-shaped and comprises two parallel arms 12a, 12b, which extend from a central body 12c; on the latter the inductance 6 is wound, which consists of a coil having a relatively low number N of loops, comprised between 20 and 35, preferably 30, made of conducting material (e.g. copper or alloys thereof), and having a circular cross-section with a diameter fit for the specific application.

In accordance with a preferred embodiment, the conductor is wound into the coil 6 on two or more orders of concentric loops, thus obtaining corresponding coaxial coils wound around the central body 12c of the first ferromagnetic core 3, without increasing the length of the latter.

This reduces the overall dimensions of the induction heads 1 along the edge of the layers to be welded. Furthermore, this provides a higher induction level, the length of the inductor core 13 and other conditions (supply voltage and current, cross-section of the wound conductor, etc.) being equal.

In order to prevent the overlapped winding orders of the loops from excessively increasing the diameter of the coil 6, the top face 13 of the central body 12c of the inductor core 3 is advantageously flat, not cylindrical like the other core parts.

In accordance with a preferred embodiment of the invention, the welding area and/or the inductor coil 3 are cooled.

For this purpose, along the arms 12a, 12b there are grooves 30, 31 extending longitudinally on the arms' outer side; the grooves are used for letting out the air blown into the structure 2 that houses the ferromagnetic core 3 through apertures 32, 33 and a collector channel 34 in the upper part of the structure 2.

The latter is preferably made up of two parts: a first part 20 comprising a cavity 21, the shape of which is conjugated to that of the inductor core 3, and a second part 22 substantially shaped like a plate, which acts as a face for closing the first part 20, to which it is secured by means of screws or the like, which are not shown in the drawings because they are *per se* known.

The collector 34 is connected to air supply tubes (not shown in the drawings) of the machine where the welding head 1 is installed.

The air flow enters the enclosure 2 through the apertures 32, 33 and comes out at the terminal regions of the arms 12a, 12b after having flowed along the grooves 30, 31 extending longitudinally thereto; in this manner, heat can be removed from the area most subjected to thermal stress during the multilayer welding cycle, thereby improving the reliability of the process even if smaller induction heads are used, all other conditions, such as supply voltage and current, thickness of the multilayer to be welded, etc., being equal.

For these purposes, the air flow rate, the air temperature and other parameters affecting the welding process are controlled and managed by a control system of the machine, as will be described below.

The smaller size of the induction head also reduces the area of thermal exchange between the inductor core 3 and the region of the multilayer to be welded: it would not therefore be possible to use the same supply current and voltage.

However, the cooling of the head 1 according to the invention allows maintaining the same operating parameters, so as to obtain the induction required by the welding process without the risk of reaching excessive temperatures that might locally damage the material.

In fact, the higher the power required, the bigger the cross-section of the conductor and of the inductor core 3 must be; it must also be pointed out that, depending on the number of loops and on the type of induction head, as will be explained below, the supply current will vary from 10 to 14 Amperes, with a voltage in the range of 300 to 560 Volts.

The free ends of the two arms 12a, 12b of the inductor core 3 have opposite magnetic polarities, so that the flux generated by the inductance 6 will develop along a magnetic circuit extending from the first inductor core 3 to the second core 4 while crossing the air gap between them, where there is a stack of layers to be welded for manufacturing printed circuits.

In this example, the second inductor core 4 consists of a bar or plate made of the same material (ferrite) as the first one; the thickness of the plate and its dimensions are proportional to the magnetic flux circulating in the circuit.

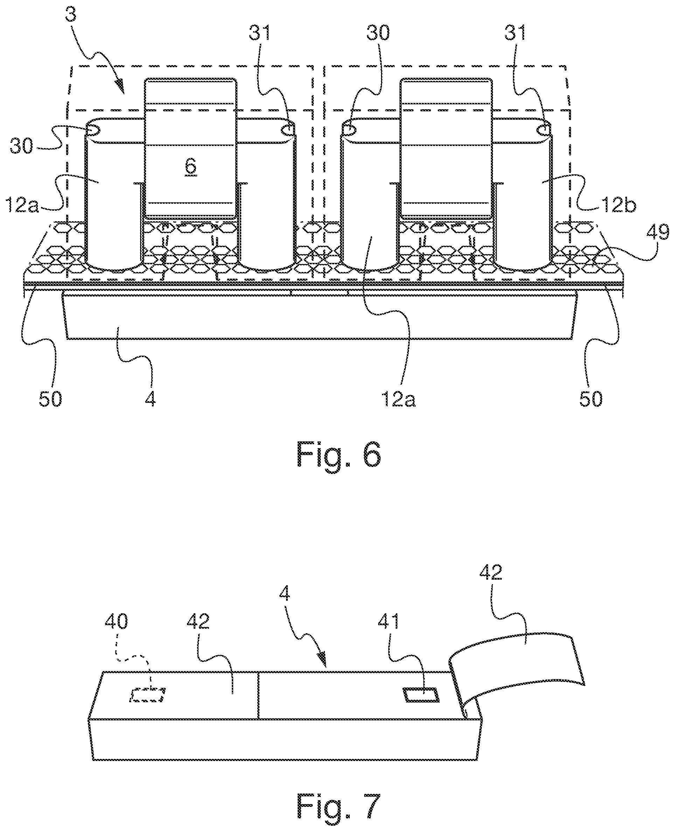

In accordance with a preferred embodiment, the extension of the second inductor core 4 is greater than that of the first core 3, so that it can advantageously be used as a magnetically associated element for two or more welding heads 1 mounted close to each other on the same machine, as shown in Figure 6.

To this end, the cross-section of the second core 4 must be equal to or greater than that of the first core 3, so as to facilitate the passage of the magnetic flux, as will be further described below.

Advantageously, on the second core 4 metallic plaquettes 40, 41 are present at points juxtaposed to the ends of the arms 12a, 12b of the first core 3.

Such plaquettes are made of copper or another electrically conducting material, and are heated through the effect of the currents induced therein, thus having a temperature similar to that of the multilayer stack of laminates and promoting the welding action; preferably, in order to prevent deposits or scales of melted resin coming from the "pre-preg" insulating layers from forming on the plaquettes 40, 41 and on the second core 4, which might reduce the efficiency of the system, strips 42 of plastic film are applied onto the second core 4.

It must however be pointed out that the plaquettes 40, 41 may alternatively be applied onto the ends of the arms 12a, 12b of the first core 3, instead of on the second core 4. The induction head 1 according to the invention allows joining stacks 48 of overlapped layers to be welded, comprising conducting layers 49 alternated with insulating layers 50, the former carrying the topography of the printed circuit 51 to be manufactured, and the latter consisting of the above-mentioned pre-preg.

Furthermore, the conducting layers 49 have a peripheral belt 52 in which conducting spacers 55 are arranged; the latter are elements made of electrically conducting metallic material (e.g. copper), the thickness of which is substantially equal to that of the printed circuit 51, and therefore may vary from a few tenths of a millimetre to a few millimetres, depending on the application.

The spacers 55 have a circular, elliptical, polygonal (quadrilateral, hexagonal, etc.) or mixed shape, and are evenly distributed (in orderly rows, in a matrix or quincunx pattern, etc.); their area may vary from 3 to 30 mm², and they are spaced evenly at a distance preferably of the order of 1-2 millimetres.

In this way, it is possible to obtain a buffer region or belt 52 along the edge of the conducting layers 49, consisting of a plurality of evenly distributed spacers 55: the width of said belt may vary from 4-5 centimetres to 1 centimetre or even less.

It should be noted that in the layers 49, 50 of the stack 48 there are no short-circuited loops or other equivalent elements arranged in predetermined areas, which on the contrary are present in prior-art multilayer stacks: The welding heads 1 according to the invention can therefore be arranged at any point along the sides of the multilayer stack 48 for making a junction, as described below.

The sheets 49, 50 that make up the multilayer stack 48 are accurately stacked with the aid of suitable centering devices or holders, as already known in these applications.

For welding, the multilayer stack 48 thus prepared is positioned with its buffer belt 52 interposed between each welding head 1 and the second inductor core 4 associated therewith: the heads can be arranged in any position relative to the multilayer stack 48, since according to the invention the junction can be made at any point of the buffer belt 52.

It will however be understood that, in general, it is preferable to have a homogeneous distribution of the junction spots along the edges of the stack 48, so as to obtain a stronger junction and a more stable configuration; therefore, the induction heads 1 will generally be distributed evenly along the edge of the multilayer stack 48.

In this regard, it must be pointed out that, at the beginning of an operating cycle, the inductor cores 3 and 4 of each head 1 are spaced apart to allow inserting therebetween the multilayer stack 48, the thickness of which may vary from time to time; the distance between the cores 3 and 4 is however adjusted in such a way as to bring them into contact with the top and bottom faces, respectively, of the multilayer stack 48. To this end, the machine where the induction heads 1 have been mounted is equipped with *per se* known means for adjusting the distance between the cores 3 and 4, such as, for example, screw mechanisms, hydraulic cylinders, etc.

In this operating condition, power can be supplied to the inductance 6 of each head 1 in order to generate an induction in the first core 3, which will then develop in the magnetic circuit that includes the second inductor core 4 and the air gap 46, where the multilayer stack has been inserted 48.

It follows that the magnetic flux exiting from one of the poles 12a, 12b of the first core 3 will enter again laterally from the other pole of the same core, and vice versa, after having crossed the second core 4 with no dispersion towards the outside: the multilayer stack 48 to be welded is thus crossed throughout its thickness by the magnetic flux at two distinct points in the same manner because, due to the particular structure of the welding head 1, the magnetic flux exiting from one of the poles of the inductor core 3 will be the same as the one entering again from the other pole.

Moreover, the alternating power supply of the inductance allows cyclically reversing the signs N and S (+ and -) of the polarities of the first inductor core 3, so that in normal operating conditions an optimal balance of the state of the system is attained.

In this condition, in the spacers 55 crossed by the high-frequency alternating magnetic flux supplied to the inductance 6 (18 to 30 kHz) parasite currents are induced which cause local heating of the conducting layers 49, so that the resin with which the pre-preg insulating layers 50 are impregnated can cure, thereby providing the desired junction.

In accordance with a preferred embodiment of the invention, during the application of magnetic induction, i.e. when power is being supplied to the coil 6, the air flow along the grooves 30, 31 is at least partly interrupted in order to facilitate the local heating of the spots to be welded. In this context, it is necessary to stress the importance of having a plurality of separate elements, i.e. the spacers 55, which are crossed by a uniform magnetic flux.

In fact, the induced magnetic flux in which the spacers are immersed is concordant, i.e. either positive or negative depending on the alternating current cycles of the inductance 6; in addition, the spacer elements 55 are small compared to the cross-section of the inductor cores 3 and 4, being on average 10 to 20 times smaller, so that the field that flows through them is substantially constant for each of them.

It must also be underlined that, once the resin has melted and diffused, all the magnetic flux induced in the cores 3 and 4 will flow through the multilayer stack 48, since it will be wholly concatenated therewith; in other words, the vectorial sum of the magnetic field that flows through the multilayer stack 48 is equal to zero.

This increases the efficiency of the induction head 1 because the stack 48 can be welded in multiple spots, in the positions of the two arms 12a, 12b of the magnetic core 3 of each head.

Such a result is also made possible by the fact that the intensity of the magnetic flux is the same (though with opposite signs) at the junction spots, since the geometry of the system is symmetrical.

This allows having the same operating conditions (temperature, induced currents, etc.) for each welding head 1, since the magnetic field is the same: it is therefore possible to control the welding process in multiple spots, which on the contrary is not possible with prior-art welding heads, which can only weld in one spot.

This effect is advantageously exploited in the embodiment of the invention shown in Figure 6, wherein a single second ferromagnetic core 4 is associated with two first cores 3 supporting respective induction coils 6.

With this solution, one can weld in close spots of the multilayer stack, in a balanced manner; to this end, according to a preferred configuration, the induction coils 6 of the heads 1 associated with one same second core 4 are connected to each other in series or in parallel, so that the coils will be run by the same current, and also the magnetic induction generated by them in the respective cores 3 and 4 will be equal. During the welding process, the heads 1 can also advantageously be cooled by air or another suitable gas (e.g. nitrogen, CO₂), which is made to flow along the grooves 30, 31 extending in the arms 12a, 12b of the first core 3.

In fact, the air or gas flow also has the effect of keeping the temperature of the head 1 within suitable values ensuring proper and reliable operation, in addition to promoting the curing of the resin of the insulating layers 50, thus reducing the duration of the welding process and ensuring the proper detachment of the head 1 from the multilayer stack 48.

In this regard, it must also be pointed out that the pressure exerted by the air flow exiting the grooves 30, 31 applies a downward force onto the underlying multilayer stack 48, advantageously helping the latter separate from the induction head 1.

In other words, it can be said that the aeration system of the induction head according to the invention attains a two-fold effect: on the one hand, it maintains the temperature within preset limits even in the presence of a smaller induction head (the welding parameters, e.g. applied magnetic induction, voltage and current, being equal); on the other hand, it aids the curing of the resin and the detachment of the multilayer stack from the induction head at the end of the welding process.

In this respect, it must be stressed that the enclosure 2 of the induction head 1 is open at the ends of the arms 12a, 12b of the inductor core 3, thus allowing the circulating air or other gas to exit; this aspect differentiates the head 1 from the known ones with fixed magnetic poles on which a shielding or protection plaquette is usually applied, which would prevent the air from flowing out in accordance with the present invention.

It can be easily understood from the above description how the induction head 1 can solve the technical problem addressed by the invention.

In fact, thanks to it a multilayer stack 48 can be welded in any spot along the buffer belt where the conducting spacers 52 are arranged, thus allowing a much greater number of junction spots than the prior art: this is due to the head according to the invention, which is smaller, all other conditions being equal, than prior-art ones, so that a larger number of such heads can be used along the edge of the multilayer stack. This effect is also amplified by the configuration of the invention wherein two or more cores 3 supporting respective induction coils 6 are magnetically associated with one same core 4: this configuration allows, in fact, to better exploit the available spaces as regards both the closeness of the junction spots along the multilayer stack and the possibility of attaining advantageous synergies for powering and cooling the induction heads.

As can be understood, in fact, the closer arrangement of the cores that support the coils 6 facilitates their electric connection via the same conductors, leading to simpler electric connections; furthermore, in accordance with a preferred embodiment, it has been verified that the series connection of the power supply coils 6 is to be preferred because it provides a synergic magnetic induction effect between the coils, which maximizes the flux in the junction spots at the ends of the arms 12a, 12b.

For this reason, in accordance with a preferred variant of the invention, the coils are wound in opposite directions on the respective central elements 12c of the core: this is aimed at synchronizing the respective fields of mutual induction with those generated by the current flowing therethrough, so as to maximize the inductive effect and hence, as a result, improve the welding action.

Also the supply of air for cooling the welding heads is promoted by the closer arrangement of the respective coil supporting cores 3, since the respective grooves 30, 31 can all be connected to the same source (e.g. compressor) in a simple manner, thanks to their proximity.

In this regard, it must be pointed out that, preferably, in the heads 1 according to the invention the distance between the grooves of the arms 12a, 12b of the core is less than 10 ÷ 15 centimetres; furthermore, the minimum distance between two coil supporting cores 3 associated with the same inductor core 4 is at least approx. 1 cm.

It should also be noted that, in accordance with the principles of the invention, there may be more than two cores 3 supporting the coils 6, arranged side by side and magnetically associated with one same second inductor core 4.

Of course, the invention may be subject to many variations with respect to the description provided so far.

For example, in order to increase the flow of cooling air, more grooves 30, 31 may be present on the arms 12a, 12b of the first inductor core 3; for example, let us consider a series of grooves parallel to those shown in the drawings, distributed at a predetermined angular pitch along said arms.

Likewise, the straight shape of the grooves 30, 31, though preferable because it can be easily obtained by mechanically machining the core 3 (e.g. by milling), may be replaced by a curvilinear or spiral configuration; this is the case wherein the grooves extend helically along the arms 12a, 12b.

As a further possible variant of the invention that may be taken into consideration, the grooves for the cooling air flow may be provided in the second ferromagnetic inductor core, i.e. the one not supporting the coil.

More in general, it must be stressed that some structural and/or functional aspects of the head 1 may be reversed compared to the example described herein.

To make this aspect clear, let us consider that the positions of the inductor cores 3 and 4 could be exchanged; therefore, nothing will prevent the inductor core 3 that supports the coil from being arranged under the other inductor core 4: the latter could be equipped with grooves, similar to the above-mentioned grooves 30, 31, for the fluid that will cool the welding area.

It should also be pointed out that, although in the example taken into account herein the air is made to flow freely along the grooves 30 and 31, i.e. said grooves are used for conveying the air from the collector 34 to the welding area, other solutions may be conceived wherein the air is supplied by tubes housed in the grooves 30, 31 and extending from the collector 34 to the welding area.

In other words, with these tubes the air will not come directly into contact with the core 2, since it is the tubes themselves, which may be made of metal, plastic or another suitable material, housed in the grooves 30, 31, that exchange heat with the ferromagnetic inductor core 4.

Further variants of the invention may concern the arrangement of the inductor cores 3 that support the coils 6; in fact, in the examples shown in the drawings reference is made, for simplicity, to a core 3 arranged in a respective housing enclosure 2. However, variants are conceivable wherein two (or more) side-by-side inductor cores 3 are housed in one same enclosure 2 of larger dimensions: This variant offers the advantage that application of the inductors to a welding machine is simplified, since by moving a single enclosure one can position two (or more) inductors relative to a multilayer stack 48 to be welded.

Finally, it must be pointed out that, although air has been referred to herein as a cooling fluid flowing in the induction head 1, it can be easily understood that this is a simple and cheap solution that however does not exclude the use of other gases (preferably inert ones such as carbon dioxide, nitrogen or noble gases or anyway gases for industrial use).

All of these variants will still fall within the scope of the following claims.

## Claims

1. Induction head (1) for welding multilayer stacks (48) for printed circuits and the like, comprising a first inductor core (3) associated with an excitation inductance (6); a second inductor core (4) cooperating with the first core (3) to guide a magnetic flux to at least one junction area of a multilayer stack (48) interposed between said cores (3, 4), **characterized in that** it comprises a path (30, 31) for a cooling fluid, which extends along at least one of said first and second inductor cores (3, 4).

2. Induction head according to claim 1, wherein the path of the cooling fluid extends at least up to the junction area, so that the fluid can lap the multilayer stack (48) interposed between said first and second inductor cores (3, 4).

3. Induction head according to claim 1 or 2, wherein the path of the cooling fluid comprises at least one groove (30, 31) formed in the respective inductor core (3, 4).

4. Induction head according to any one of the preceding claims, comprising at least two first inductor cores (3) associated with respective inductances (6) and cooperating with one same second inductor core (4) to guide the magnetic flux towards corresponding junction areas of a multilayer stack (48) interposed between said first cores (3) and the second core (4).

5. Induction head according to claim 4, wherein the inductances (6) are wound in opposite directions on the respective cores (3), so as to co-ordinate the magnetic fluxes respectively associated therewith in such a way as to maximize the flux through the multilayer stack (48).

6. Induction head according to any one of the preceding claims, wherein the first core (3) is housed in an enclosure (2) which is substantially open at said at least one junction area, thus allowing the cooling fluid to flow out towards a multilayer stack interposed between said first and second cores (3, 4).

7. Induction head according to any one of the preceding claims, comprising conducting plaquettes (40, 41) arranged on said first and/or second cores (3, 4) at the junction areas of a multilayer stack (48).

8. Induction head according to any one of the preceding claims, wherein the first inductor core (3) comprises a body made of magnetically permeable material and substantially C-shaped, wherein a pair of terminal arms (12a, 12b) extend from a central portion (12c) with which an inductance (6) is associated for inducing the magnetic flux to both arms (12a, 12b).

9. Induction head according to claim 8, wherein grooves (30, 31) extend along the arms (12a, 12b) of the first inductor core (3) for the passage of the cooling fluid.

10. Induction head according to any one of the preceding claims, wherein the second inductor core (4) comprises a substantially straight element made of ferromagnetic material.

11. Method for welding multilayer stacks (48) for printed circuits, wherein at least one electrically conducting layer (49) is stacked over at least one electrically insulating layer (50) impregnated with resins or similar thermomelting substances, comprising the following steps:
i) interposing a multilayer stack (48) between at least one first inductor core (3) associated with one inductance (6) and a second inductor core (4) cooperating therewith to guide a magnetic flux to at least one junction area (52);
ii) supplying alternating current to the inductance for a period of time sufficient to ensure local melting of the resin in said junction area (52);
iii) blowing a cooling fluid towards the junction area (52) for a time sufficient to harden the previously melt resin;
iv) moving the first inductor core (3) away from the multilayer stack (48).

12. Method according to claim 11, wherein the cooling fluid is a gaseous one, preferably air.

13. Method according to claim 11 or 12, wherein the junction area is arranged at a peripheral belt (52) of the multilayer stack (48), where there are conducting spacer elements (55).

## Patentansprüche

1. Induktionskopf (1) zum Verschweißen von Mehrschichtstapeln (48) für Leiterplatten und dergleichen, umfassend einen ersten Induktorkern (3), der einer Erregungsinduktivität (6) zugeordnet ist; einen zweiten Induktorkern (4), der mit dem ersten Kern (3) zusammenwirkt, um einen magnetischen Fluss zu mindestens einem Verbindungsbereich eines zwischen den Kernen (3, 4) eingefügten Mehrschichtstapels (48) zu führen, **dadurch gekennzeichnet, dass** er einen Pfad (30, 31) für ein Kühlfluid umfasst, der sich entlang mindestens eines des ersten und des zweiten Induktorkerns (3, 4) erstreckt.

2. Induktionskopf nach Anspruch 1, wobei der Pfad des Kühlfluids sich mindestens bis zum Verbindungsbereich erstreckt, so dass das Fluid den Mehrschichtstapel (48) überlappen kann, der zwischen dem ersten und dem zweiten Induktorkern (3, 4) eingefügt ist.

3. Induktionskopf nach Anspruch 1 oder 2, wobei der Pfad des Kühlfluids mindestens eine Rille (30, 31) umfasst, die im entsprechenden Induktorkern (3, 4) ausgebildet ist.

4. Induktionskopf nach einem der vorhergehenden Ansprüche, umfassend mindestens zwei erste Induktorkerne (3), die entsprechenden Induktivitäten (6) zugeordnet sind und die mit einem gleichen zweiten Induktorkern (4) zusammenwirken, um den magnetischen Fluss zu entsprechenden Verbindungsbereichen eines Mehrschichtstapels (48) zu führen, der zwischen den ersten Kernen (3) und dem zweiten Kern (4) eingefügt ist.

5. Induktionskopf nach Anspruch 4, wobei die Induktivitäten (6) auf den entsprechenden Kernen (3) in entgegengesetzten Richtungen gewickelt sind, um die magnetischen Flüsse zu koordinieren, die ihnen auf solche Weise zugeordnet sind, um den Fluss durch den Mehrschichtstapel (48) zu maximieren.

6. Induktionskopf nach einem der vorstehenden Ansprüche, wobei der erste Kern (3) in einem Gehäuse (2) untergebracht ist, das an dem mindestens einen Verbindungsbereich im Wesentlichen offen ist und dadurch das Ausfließen des Kühlfluids zu einem Mehrschichtstapel ermöglicht, der zwischen den ersten und zweiten Kernen (3, 4) eingefügt ist.

7. Induktionskopf nach einem der vorstehenden Ansprüche, umfassend leitfähige Plaketten (40, 41), die auf den ersten und/oder zweiten Kernen (3, 4) an den Verbindungsbereichen eines Mehrschichtstapels (48) angeordnet sind.

8. Induktionskopf nach einem der vorstehenden Ansprüche, wobei der erste Induktorkern (3) einen Körper umfasst, der aus magnetisch permeablem Material hergestellt und im Wesentlichen C-förmig ist, wobei ein Paar von Klemmenarmen (12a, 12b) sich von einem zentralen Abschnitt (12c) aus erstreckt, dem eine Induktivität (6) zugeordnet ist, um den magnetischen Fluss zu beiden Armen (12a, 12b) zu induzieren.

9. Induktionskopf nach Anspruch 8, wobei sich Rillen (30, 31) für den Durchlauf des Kühlfluids entlang der Arme (12a, 12b) des ersten Induktorkerns (3) erstrecken.

10. Induktionskopf nach einem der vorstehenden Ansprüche, wobei der zweite Induktorkern (4) ein im Wesentlichen gerades Element umfasst, das aus ferromagnetischem Material hergestellt ist.

11. Verfahren zum Verschweißen von Mehrschichtstapeln (48) für Leiterplatten, wobei mindestens eine elektrisch leitfähige Schicht (49) über mindestens einer elektrisch isolierenden Schicht (50) gestapelt ist, die mit Harzen oder ähnlichen wärmeschmelzenden Substanzen imprägniert ist, umfassend die folgenden Schritte:
i) Einfügen eines Mehrschichtstapels (48) zwischen mindestens einen ersten, einer ersten Induktivität (6) zugeordneten, Induktorkern (3) und einen zweiten Induktorkern (4), der damit zusammenwirkt, um einen magnetischen Fluss zu mindestens einem Verbindungsbereich (52) zu führen;
ii) Zuführen von Wechselstrom zur Induktivität über einen ausreichenden Zeitraum, um lokales Schmelzen des Harzes im Verbindungsbereich (52) sicherzustellen;
iii) Blasen von Kühlfluid zum Verbindungsbereich (52) über einen zum Härten des zuvor geschmolzenen Harzes ausreichenden Zeitraum;
iv) Wegbewegen des ersten Induktorkerns (3) vom Mehrschichtstapel (48).

12. Verfahren nach Anspruch 11, wobei das Kühlfluid ein gasförmiges, vorzugsweise Luft, ist.

13. Verfahren nach Anspruch 11 oder 12, wobei der Verbindungsbereich an einem peripheren Band (52) des Mehrschichtstapels (48) angeordnet ist, wo leitfähige Abstandselemente (55) vorhanden sind.

## Revendications

1. Tête d'induction (1) pour souder des empilements multicouches (48) pour des circuits imprimés et similaires, comprenant un premier noyau d'inducteur (3) associé à une inductance d'excitation (6) ; un second noyau d'inducteur (4) coopérant avec le premier noyau (3) pour guider un flux magnétique jusqu'au moins une zone de jonction d'un empilement multicouche (48) interposé entre lesdits noyaux (3, 4), **caractérisée en ce qu'**elle comprend un chemin (30, 31) pour un fluide de refroidissement, qui s'étend le long d'au moins l'un desdits premier et second noyaux d'inducteur (3, 4).

2. Tête d'induction selon la revendication 1, dans laquelle le chemin du fluide de refroidissement s'étend au moins jusqu'à la zone de jonction, de sorte que le fluide puisse chevaucher l'empilement multicouche (48) interposé entre lesdits premier et second noyaux d'inducteur (3, 4).

3. Tête d'induction selon la revendication 1 ou 2, dans laquelle le chemin du fluide de refroidissement comprend au moins une gorge (30, 31) formée dans le noyau d'inducteur (3, 4) respectif.

4. Tête d'induction selon l'une quelconque des revendications précédentes, comprenant au moins deux premiers noyaux d'inducteur (3) associés à des inductances (6) respectives et coopérant avec un même second noyau d'inducteur (4) pour guider le flux magnétique vers des zones de jonction correspondantes d'un empilement multicouche (48) interposé entre lesdits premiers noyaux (3) et le second noyau (4).

5. Tête d'induction selon la revendication 4, dans laquelle les inductances (6) sont enroulées dans des directions opposées sur les noyaux (3) respectifs, de façon à coordonner les flux magnétiques associés respectivement à ceux-ci de façon à maximiser le flux à travers l'empilement multicouche (48).

6. Tête d'induction selon l'une quelconque des revendications précédentes, dans laquelle le premier noyau (3) est logé dans une enceinte (2) qui est sensiblement ouverte au niveau de ladite au moins une zone de jonction, permettant ainsi au fluide de refroidissement de sortir vers un empilement multicouche interposé entre lesdits premier et second noyaux (3, 4).

7. Tête d'induction selon l'une quelconque des revendications précédentes, comprenant des plaquettes conductrices (40, 41) agencées sur lesdits premier et/ou second noyaux (3, 4) au niveau des zones de jonction d'un empilement multicouche (48).

8. Tête d'induction selon l'une quelconque des revendications précédentes, dans laquelle le premier noyau d'inducteur (3) comprend un corps réalisé en matériau magnétiquement perméable et sensiblement en forme de C, dans laquelle une paire de bras terminaux (12a, 12b) s'étendent entre une portion centrale (12c) à laquelle l'inductance (6) est associée pour induire le flux magnétique vers les deux bras (12a, 12b).

9. Tête d'induction selon la revendication 8, dans laquelle des gorges (30, 31) s'étendent le long des bras (12a, 12b) du premier noyau d'inducteur (3) pour le passage du fluide de refroidissement.

10. Tête d'induction selon l'une quelconque des revendications précédentes, dans laquelle le second noyau d'inducteur (4) comprend un élément sensiblement droit réalisé en matériau ferromagnétique.

11. Procédé de soudage d'empilements multicouches (48) pour des circuits imprimés, dans lequel au moins une couche électriquement conductrice (49) est empilée sur au moins une couche électriquement isolante (50) imprégnée de résines ou de substances de thermofusion similaires, comprenant les étapes suivantes :
i) l'interposition d'un empilement multicouche (48) entre au moins un premier noyau d'inducteur (3) associé à une inductance (6) et un second noyau d'inducteur (4) coopérant avec celui-ci pour guider un flux magnétique jusqu'au moins une zone de jonction (52) ;
ii) la fourniture de courant alternatif à l'inductance pendant une période de temps suffisante pour garantir une fusion locale de la résine dans ladite zone de jonction (52) ;
iii) le soufflage d'un fluide de refroidissement vers la zone de jonction (52) pendant un temps suffisant pour durcir la résine précédemment fondue ;
iv) l'éloignement du premier noyau d'inducteur (3) de l'empilement multicouche (48).

12. Procédé selon la revendication 11, dans lequel le fluide de refroidissement est un fluide gazeux, de préférence de l'air.

13. Procédé selon la revendication 11 ou 12, dans lequel la zone de jonction est agencée au niveau d'une courroie périphérique (52) de l'empilement multicouche (48), où se trouvent des éléments d'entretoise conducteurs (55).
